(19) **Europäisches Patentamt**
**European Patent Office**
**Office européen des brevets**

(11) **EP 1 580 563 B1**

(12) **EUROPÄISCHE PATENTSCHRIFT**

(45) Veröffentlichungstag und Bekanntmachung des Hinweises auf die Patenterteilung:
**02.05.2007 Patentblatt 2007/18**

(51) Int Cl.:
*G01R 15/20* *(2006.01)*     *G01R 33/09* *(2006.01)*

(21) Anmeldenummer: **05101884.4**

(22) Anmeldetag: **10.03.2005**

(54) **Vorrichtung zur potenzialfreien Strommessung**

Arrangement for potential-free current measurements

Dispositif pour la mesure sans potentiel de courants

(84) Benannte Vertragsstaaten:
**DE FR IT SE**

(30) Priorität: **23.03.2004 DE 102004014212**
**23.12.2004 DE 102004062474**

(43) Veröffentlichungstag der Anmeldung:
**28.09.2005 Patentblatt 2005/39**

(73) Patentinhaber: **SIEMENS AKTIENGESELLSCHAFT**
**80333 München (DE)**

(72) Erfinder:
• **Ludwig, Klaus**
**91058, Erlangen (DE)**
• **Rieger, Gotthard**
**91058, Erlangen (DE)**

(56) Entgegenhaltungen:
WO-A-02/069356     DE-A1- 3 929 452
DE-A1- 10 103 398     US-A- 5 708 407

• **PATENT ABSTRACTS OF JAPAN Bd. 2002, Nr. 04, 4. August 2002 (2002-08-04) & JP 2001 345496 A (CANON INC), 14. Dezember 2001 (2001-12-14)**

**Beschreibung**

Die Erfindung bezieht sich auf eine Vorrichtung zur potenzialfreien Messung eines in einem axial lang gestreckten elektrischen Leiter fließenden Leiterstromes mit mindestens einem dem Leiter zugeordneten, demgegenüber elektrisch isolierten Sensorelement mit magnetoresistiven Eigenschaften und mit Mitteln zum Abgriff des vom Magnetfeld des Stromes abhängigen Widerstandswertes über dem Element und zur Weiterverarbeitung dieses Wertes. Eine entsprechende Vorrichtung ist der WO 95/09447 A zu entnehmen. Eine ähnliche Vorrichtung ist ebenfalls aus der DE 101 03 398 A zu entnehmen.

Die potenzialfreie Strommessung findet Anwendung im gesamten Bereich der elektrischen Energieübertragung, des Power-Managements, der Steuerungs- und Automatisierungstechnik. Da es sich häufig um eine sicherheitsrelevante Funktion handelt, muss der eingesetzte potenzialfreie Stromwandler gegenüber äußeren Störeinflüssen bzw. Feldern geschützt werden. Stehen kostengünstige und geometrisch einfache Lösungen zur Verfügung, kann die Stromüberwachung an vielen Stellen frühzeitig eingreifen und Schäden verhindern.

Zu einer potenzialfreien Stromerfassung bzw. -messung existieren heute unterschiedliche Lösungen, wobei z.B. Messwiderstände (Shunts), kombiniert mit Optokopplern, ferner Stromwandler (Transformatoren), Hall-Elemente, Feldplatten, Sensorsysteme unter Verwendung von magnetoresistivem Material sowie faseroptische Strommessungseinrichtungen zum Einsatz kommen. Viele der Stromsensoren besitzen jedoch einen begrenzten Einsatzbereich, sind z.B. auf eine Wechselstrommessung begrenzt, da sie auf induktiven Prinzipien basieren, oder sind nicht integrierbar. Ein Problem bei den erwähnten magnetischen Lösungen, in denen das Feld eines stromdurchflossenen Leiters gemessen wird, entsteht dadurch, dass ein Störfeld häufig sehr direkt einwirkt und ständig Schirmungseinrichtungen oder Gradienten- bzw. Kompensationsmethoden eingesetzt werden müssen.

Aus der eingangs genannten WO-A-Schrift geht eine Strommessvorrichtung hervor, die mindestens ein Sensorelement umfasst, das in Form eines offenen Ringes einen stromdurchflossenen Leiter umgibt. Dabei ist der offene Ring durch ein Multilagensystem aus metallischem magnetoresistiven Material vom sogenannten AMR (Anisotropic Magneto Resistance)-Typ gebildet. An den benachbarten, einen Schlitz bildenden Enden dieses Ringes ist das magnetoresistive Material zum Abgriff des Widerstandswertes kontaktiert. Ein solches Sensorelement kann mit weiteren, nicht-magnetfeldsensitiven Elementen zu einer Brücke verschaltet sein. Die verwendeten magnetoresistiven Materialien lassen sich nur mit erheblichem Aufwand in gekrümmte Formen wie die geforderte geschlitzte Ringform bringen.

Aus der DE 39 29 452 A1 ist ebenfalls eine Strommessvorrichtung mit den eingangs genannten Merkmalen zu entnehmen. Die bekannte Vorrichtung enthält einen Magnetfeld-Ringsensor, der ein Substrat mit zentraler Kreisöffnung zur Durchführung eines Stromleiters aufweist. Um die Kreisöffnung sind eine Vielzahl von einzelnen Sensorelementen vom sogenannten Barber-Pole-Typ angeordnet, die jeweils in Dünnschichttechnik auf dem Substrat abgeschiedene, radial ausgerichtete Streifen aus magnetoresistivem Material und schräg dazu verlaufende elektrische Leiterteile aufweisen. Die einzelnen, untereinander in Umfangsrichtung gesehen deutlich beabstandeten Sensorelemente sind elektrisch hintereinander geschaltet. Der Aufbau dieser bekannten Vorrichtung ist sehr aufwendig.

Aufgabe der vorliegenden Erfindung ist es, die bekannten Strommessvorrichtungen dahingehend auszugestalten, dass ihr Aufbau bei hinreichender Empfindlichkeit vereinfacht ist.

Diese Aufgabe wird mit den in Anspruch 1 angegebenen Maßnahmen erfindungsgemäß gelöst. Dementsprechend soll das mindestens eine aus magnetoresistivem Material gebildete Sensorelement eine in Umfangsrichtung um den Leiter magnetisch geschlossene Schleife mit vorbestimmter axialer Ausdehnung bilden und soll der Abgriff des Widerstandswertes an axial gegenüberliegenden Enden des Sensorelementes erfolgen.

Mit dieser Ausgestaltung der Strommessvorrichtung ergibt sich vorteilhaft die Möglichkeit, ihr mindestens ein Stromsensorelement in einfacher Weise aufzubauen : Durch eine dünne Isolationsschicht galvanisch getrennt befindet sich eine magnetisch praktisch vollständig geschlossene Schleife, insbesondere in Ring- oder Hülsenform, aus metallischem oder insbesondere nicht-metallischem magnetoresistiven Material im Magnetfeldwirbel des stromführenden elektrischen Leiters. Diese Schleife hat eine vorbestimmte, ausgeprägt axiale Ausdehnung, die deutlich über der Dicke von magnetoresistiven Dünnfilmen liegt und insbesondere mindestens 1 mm beträgt. In der magnetisch geschlossenen Schleife ist folglich ein geschlossener magnetischer Fluss zu erzeugen, der sehr effektiv das rotationssymmetrische Feld des Leiters zu einer Aufmagnetisierung des magnetoresistiven Materials und damit zu einem entsprechend hohen magnetoresistiven Effekt bzw. Ausgangssignal nutzt, ohne dass es besonderer zusätzlicher elektrisch leitender Elemente wie bei magnetoresistiven Sensorelementen vom Barber-Pole-Typ bedarf. Der Einfluss homogen überlagerter Felder wie Störfelder ist dabei vorteilhaft gering. Sowohl die Fertigung entsprechender Schleifen als auch deren Kontaktierung an den axial gegenüberliegenden Seiten ihres magnetoresistiven Materials ist besonders einfach.

Vorteilhafte Ausgestaltungen der erfindungsgemäßen Strommessvorrichtung gehen aus den abhängigen Ansprüchen hervor. Dabei kann die Ausführungsform nach Anspruch 1 mit den Merkmalen eines der Unteransprüche oder vorzugsweise auch mit denen aus mehreren Unteransprüchen kombiniert werden. Demgemäß können für die Strommessvorrichtung zusätzlich noch folgende Merkmale vorgesehen werden:

- So kann für den magnetoresistiven Teil des Sensorelementes als metallisches Material ein einen AMR-Effekt zeigendes Material vorgesehen sein, wobei der magnetoresistive Teil nach bekannten Verfahren auszubilden ist.

- Bevorzugt kann stattdessen als ein nicht-metallisches Material ein Pulver-Material mit hohem magnetoresistiven Effekt vorgesehen sein. Unter einem hohen magnetoresistiven Effekt wird in diesem Zusammenhang ein in üblicher Weise definierter Wert von mindestens 3 % bei Raumtemperatur verstanden. Dabei kann als Pulver-Material vorteilhaft ein Pulver-Verbundmaterial gewählt werden, worunter eine Zusammensetzung von mindestens zwei verschiedenen Materialien verstanden wird, in der eine Partikelstruktur noch erkennbar ist. Das Material kann in bekannter Weise hergestellt und verarbeitet sein. Solche Verbundwerkstoffe sind insbesondere den sogenannten Colossal-Magneto-Resistance(CMR)- oder Tunnel-Magneto-Resistance(TMR)- Werkstoffen (vgl. z.B. Broschüre "XMR-Technologien (Technologieanalyse- Magnetismus Band 2)" des VDI-Technologiezentrums "Physikalische Technologien", Düsseldorf(DE), 1997, Seiten 26 bis 27 und 37 bis 43) zuzurechnen. Sie ermöglichen vorteilhaft eine beliebige 3D-Formgebung. Da sich diese Werkstoffe zudem weichmagnetisch verhalten, kann von ihnen der erzeugte magnetische Fluss sehr gut geführt werden.

- Besonders geeignet ist ein Pulver-Verbundmaterial, das Partikel aus wenigstens einer Heusler- oder Halb-Heusler-Phase enthält, denen ein geringer Anteil mindestens eines oxidischen Materials, vorzugsweise unter 25 Vol.-%, zugemischt ist.

- Stattdessen kann das Pulver-Material Partikel aus wenigstens einer Mangan-Perowskit-Phase enthalten, denen gegebenenfalls zur Bildung eines Verbundmaterials ein geringer Anteil eines organischen Materials zugemischt ist. Der zugemischte Anteil in dem Pulver-Verbundmaterial kann auch hier vorteilhaft unter 25 Vol.-% liegen. Mit diesen Materialien lassen sich hochmagnetoresistive Verbundwerkstoffe mit hinreichender Flexibilität ausbilden.

- Selbstverständlich kann die Strommessvorrichtung mehrere Sensorelemente aufweisen, die in der axialen Längsrichtung des Leiters gesehen hintereinander angeordnet sind. Dabei können vorteilhaft die in die axiale Längsrichtung weisenden Vorzugsrichtungen der Magnetisierung von Element zu Element entgegengesetzt sein. Solche Elemente lassen sich dann in einfacher Weise zu einer Voll- oder Teilbrücke verschalten. Es sind so z.B. Temperatureinflüsse der einzelnen Sensorelemente in hohem Maße zu kompensieren.

- Außerdem oder stattdessen kann das mindestens eine Sensorelement in mehrere Teilelemente unterteilt sein, wobei insbesondere die Teilelemente in Umfangsrichtung um den Leiter gesehen verteilt angeordnet sind. Ein solcher Aufbau erleichtert zum einen die Montage des Elementes um einen elektrischen Leiter herum. Zum anderen ist auch hier die Ausbildung einer Voll- oder Teilbrücke möglich, wobei ebenfalls antiparallel ausgerichtete Vorzugsrichtungen der Magnetisierung benachbarter Teilelemente eingestellt werden sollten.

- Weiterhin ist es als besonders vorteilhaft anzusehen, wenn das mindestens eine Sensorelement mit einer hochpermeablen Abschirmumhüllung versehen wird. Die Kombination des Sensorelementes mit einer derartigen Umhüllung ermöglicht eine sehr effektive Schirmung. Außerdem erhält man so einen z.B. in die Isolation eines Stromkabels einfach zu integrierenden Stromsensor.

Weitere vorteilhafte Ausgestaltungen der erfindungsgemäßen Strommessvorrichtung gehen aus den vorstehend nicht angesprochenen Unteransprüchen und der Zeichnung hervor.

Die Erfindung wird nachfolgend anhand bevorzugter Ausführungsbeispiele von Messvorrichtungen unter Bezugnahme auf die Zeichnung noch weiter erläutert. Von deren Figuren zeigen in leicht schematisierter Darstellung

| | |
|---|---|
| deren Figur 1 | eine solche Messvorrichtung mit einem einzelnen Sensorelement in Schrägansicht, |
| deren Figur 2 | eine andere Ausführungsform einer Messvorrichtung mit einer Halb- oder Vollbrücke aus mehreren verschalteten Sensorelementen in Seitenansicht, |
| deren Figur 3 | eine weitere Ausführungsform einer Messvorrichtung mit einer Vollbrücke aus Sensor-Teilelementen in Querschnittsansicht, |
| deren Figuren | 4 und 5 die Messvorrichtungen nach Figur 1 bzw. Figur 2 jeweils mit einer Abschirmumhüllung in Seitenansicht |

sowie

| | |
|---|---|
| deren Figur 6 | die Messvorrichtung nach Figur 4 in einer stirnseitigen Aufsicht. |

Dabei sind in den Figuren sich entsprechende Teile jeweils mit denselben Bezugszeichen versehen.

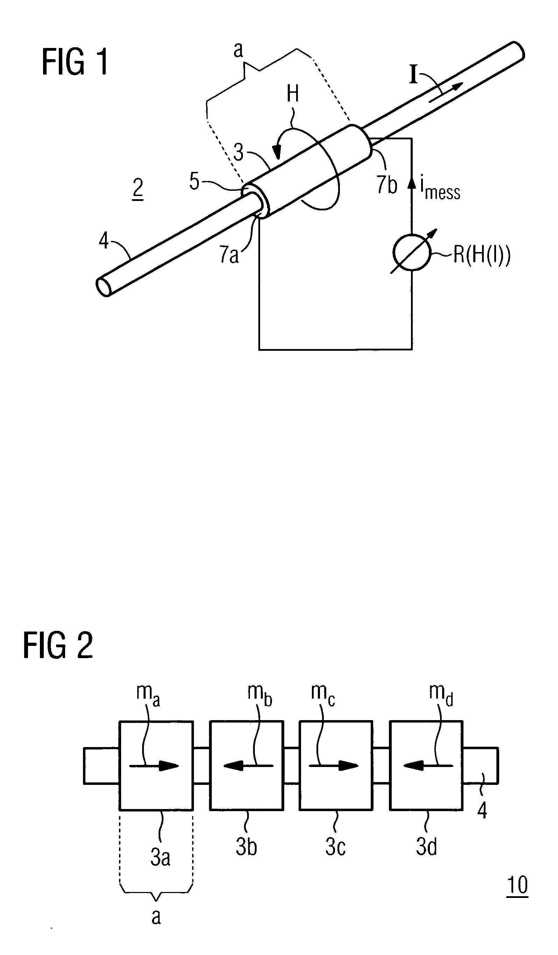

Die in Figur 1 dargestellte Strommessvorrichtung 2 nach der Erfindung umschließt mit einem Sensorelement 3 einen von einem Gleich- oder Wechselstrom I durchflossenen elektrischen Leiter 4. Dabei ist das Sensorelement 3 gegenüber dem Stromleiter 4 galvanisch getrennt, beispielsweise mittels einer dünnen Isolationsschicht 5 isoliert. Das Sensorelement weist insbesondere eine Ring- oder Hülsenform auf, die eine den elektrischen Leiter 4 in Umfangsrichtung gesehen magnetisch vollständig umschließende Umhüllung darstellt. Das Sensorelement hat dabei eine vorbestimmte, in axialer Richtung ausgeprägte Ausdehnung, die mindestens 1 mm betragen sollte. Es besteht zumindest zu einem wesentlichen Teil aus einem magnetoresistiven Material. Hierfür kommen prinzipiell alle an sich bekannten Materialien mit XMR-Effekt (vgl. die genannte Broschüre "XMR-Technologien", Seiten 11 bis 43) in Frage. Dabei kann der magnetoresistive Teil des Sensorelementes 3 aus einem metallischen oder nicht-metallischen Material nach bekannten Verfahren ausgebildet sein. So kann beispielsweise eine metallische Dick- oder insbesondere Dünn-Schicht aus einem AMR-Material vorgesehen werden. Besonders geeignet ist ein nicht-metallisches Pulver-Material, insbesondere ein Pulver-Verbundmaterial, das einen hohen magnetoresistiven Effekt von mindestens 3 % (gemäß üblicher Definition) zeigt. Das Material kann mit insbesondere aus der Pulververarbeitungstechnologie her bekannten Verfahren ausgebildet sein, wobei es auch auf einen Träger aufzubringen ist. So kommen z.B. Sinter-, Formpress-, Sprüh-/Spritz-, Dick- oder Dünnschicht-, Schlicker-/Pasten- oder Print-Verfahren in Frage.

Für die Ausführungsbeispiele sei nachfolgend ein nicht-metallischer Pulver-Verbundwerkstoff mit hohem CMR- oder TMR-Effekt ausgewählt. Dieser Werkstoff weist Partikel bzw. Pulver aus wenigstens einem magnetoresistiven oder gegebenenfalls sogar nicht- magnetoresistiven Material auf, wobei der Anteil an diesem Material vorteilhaft sehr hoch gewählt wird und beispielsweise über 75 Vol.-% beträgt. Der restliche Anteil wird von mindestens einem weiteren Material wie insbesondere einem oxidischen oder organischen Material gestellt, wobei gegebenenfalls mit diesem Zusatzstoff erst die magnetoresitiven Eigenschaften einzustellen sind. Ein bevorzugtes Beispiel für ein solches hochmagnetoresistives Pulver-Verbundmaterial sieht als Hauptkomponente insbesondere Pulverpartikel mit Heusler- oder Halb-Heusler- Phasen vor. Es ist nämlich bekannt, dass mit Pulver aus diesen zunächst praktisch nicht-magnetoresistiven Materialien zusammen mit einer geringen Menge eines oxidischen Materials, das als Korngrenzenbildner fungiert, Pulver-Verbundwerkstoffe mit hohem magnetoresistiven TMR-Effekt herstellbar sind (vgl. z.B. Dissertation von Thomas Block: "Neue Materialien für die Magnetoelektronik: Heusler- und Halb-Heusler-Phasen", Johannes Gutenberg-Universität Mainz, 2002, insbesondere Kap. "Komposit-Material", Seiten 159 bis 177). Hierbei kommen insbesondere folgende Legierungen in Frage:

$$CoV_{1-x}Mn_xSb$$

$$Co_2CrAl$$

$$Co_2Cr_{0,6}Fe_{0,4}Al$$

$$Co_2Cr_{0,6}Fe_{0,4}Ga$$

Dabei können einzelne Komponenten der vorgenannten Materialien in bekannter Weise durch andere Komponenten substituiert sein, wobei auch mehrere Substituenten eine Komponente ersetzen können.

Als Zusatzmaterialien für die vorgenannten Hauptkomponentenpulver kommen nicht-magnetische Materialien, insbesondere Oxide wie $Cr_2O_3$ oder $Al_2O_3$ in Frage. Wesentlich ist dabei, dass diese Materialien in dem Verbundwerkstoff Korngrenzen bilden, die eine Voraussetzung für einen TMR-Effekt sind.

Auch Mn-Perowskit-Materialien sind wegen des in dieser Substanzgruppe auftretenden CMR-Effektes besonders geeignet. Entsprechende bekannte Perowskite sind insbesondere vom System $Ln_{1-x}A_xMnO_{3+d}$, wobei als A-Komponente ein Erdalkalimetall gewählt wird (vgl. z.B. DE 43 10 318 C2). Die Struktur sowie die physikalischen Eigenschaften solcher Perowskite werden außer durch die Zusammensetzung in starkem Masse auch durch die Stöchiometrie des Sauerstoff-Index' d bestimmt, welche durch die geeignete Wahl der Temperatur und des Sauerstoffpartialdrucks in bekannter Weise eingestellt werden kann. Es ist auch bekannt, dass sich mit diesen Materialien unter Beimengung geringer Anteile an organischem Material wie insbesondere Polymer-Werkstoffen hochmagnetoresistive Elemente mit guter Formbarkeit herstellen lassen (vgl. z.B. Beitrag von S. Barth: "LSMO-Siebdruckschichten für CMR-Anwendungen" während des Symposiums "Magnetoresistive Sensoren VI: Grundlagen, Herstellung, Anwendung", Wetzlar (DE), 13. bis 14.03.2001). Der zugemischte Anteil liegt auch hier im Allgemeinen unter 25 Vol.-%.

Der stromdurchflossene isolierte Leiter 4 erzeugt ein Magnetfeld der Stärke H, das in der rohrförmigen, magnetoresistiven Hülse des Sensorelementes 3 zu einem Widerstandswert R führt, der von der Feldstärke H bzw. dem Strom I abhängt. Dieser Widerstandswert wird dabei vorteilhaft an den axial gegenüberliegenden Enden 7a und 7b des Sensorelementes 3 bzw. dessen magnetoresistiver Hülse abgegriffen, indem man über das magnetoresistive Material des Sensorelements in axialer Richtung einen vorbestimmten Messstrom $i_{mess}$ leitet. Die mit dem Widerstandswert korrelierte Messspannung wird dann in bekannter Weise weiterverarbeitet.

Selbstverständlich kann gemäß der Darstellung der Figur 2 eine Strommessvorrichtung 10 auch mehrere Sensorelemente 3a bis 3d aufweisen, die in axialer Richtung des Leiters 4 gesehen hintereinander angeordnet sind. Diese Elemente können vorteilhaft zu einer Halb- oder Vollbrücke verschaltet sein. Hierfür werden Vorzugsrichtungen der Magnetisierungen $m_a$ bis $m_d$ in den einzelnen Elementen vorzugsweise so eingestellt, dass sie in die Längsrichtung weisen und dabei von einem Element zu dem nächsten Element entgegengesetzt gerichtet sind.

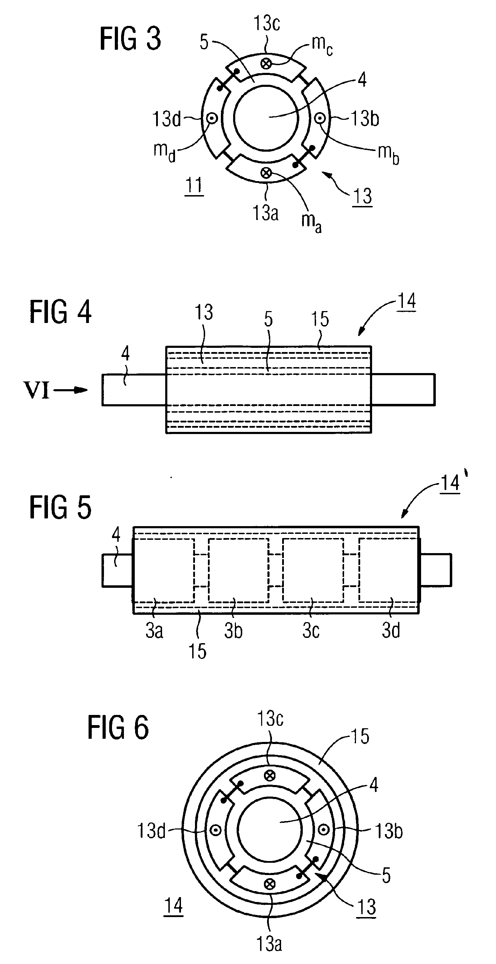

Bei den Ausführungsformen nach den Figuren 1 und 2 wurde davon ausgegangen, dass das wenigstens eine Sensorelement mindestens eine in Umfangsrichtung vollständig geschlossene Hülle aus dem hochmagnetoresistiven Verbundmaterial aufweist. Da es jedoch nur darauf ankommt, dass sich in Umfangsrichtung ein geschlossener magnetischer Ring um den elektrischen Leiter ausbildet, kann gegebenenfalls die verwendete Hülse oder der Ring auch in Teilelemente unterteilt sein, die längsseitig elektrisch isoliert, stirnseitig aber elektrisch miteinander verschaltet sind. Figur 3 zeigt eine entsprechende Ausführungsform einer Strommessvorrichtung 11 mit einem Sensorelement 13, das von vier in Umfangsrichtung verteilt nebeneinander liegenden Viertelschalenelementen 13a bis 13d gebildet wird. Dabei sollten die Luftspalte zwischen benachbarten Teilelementen möglichst klein gehalten werden. Auch hier können die Teilelemente zu einer Kompensation von Temperatureinflüssen und von quer zum Leiter gerichteten Störfeldern zu einer Vollbrücke verschaltet sind. Hierbei sollten die in die Längsrichtung weisenden Vorzugsrichtungen der Magnetisierungen $m_a$ bis $m_d$ von Teilelement zu Teilelement in Umfangsrichtung gesehen entgegengesetzt gerichtet sein. Auch Teilbrücken lassen sich mit solchen Teilelementen ausbilden. Gegebenenfalls ist es möglich, die einzelnen Sensorelemente gemäß Figur 2 mit zusammengesetzten Sensorelementen 13 nach Figur 3 zu kombinieren.

Wie aus den Figuren 4 und 5 hervorgeht, können die Ausführungsformen nach den Figuren 1 bis 3 bei einer Strommessvorrichtung 14 bzw. 14' zusätzlich noch von einer Abschirmumhüllung 15 zu einer effektiven Unterdrückung von Störfeldern umschlossen sein. Dabei sei für die in Figur 4 gezeigte Strommessvorrichtung 14 ein Sensorelement 13 nach Figur 3 vorgesehen, während die Strommessvorrichtung 14' der Figur 5 mit vier Sensorelementen 3a und 3d nach Figur 2 ausgestattet ist. Die Abschirmumhüllung 15 ist gegenüber den von ihr umschlossenen magnetoresistiven Teilen beabstandet bzw. isoliert. Die in den Seitenansichten der Figuren 4 und 5 durch die Anschirmumhüllung 15 jeweils verdeckten Teile sind durch gestrichelte Linien angedeutet.

Figur 6 zeigt die Strommessvorrichtung 14 der Figur 4 in einer Ansicht, die sich bei einer Aufsicht auf eine Stirnseite der Vorrichtung ergibt.

Nachfolgend sind zwei Abschätzungen des Störeinflusses homogen überlagerter Felder auf einen magnetoresistiven Ring oder eine Hülse unter Annahme eines linearen magnetoresistiven Effektes wiedergegeben. Dabei wird auf die Ausführungsformen von Strommessvorrichtungen nach den Figuren 1 und 2 Bezug genommen:

1) Bei rotationssymmetrischer Aufmagnetisierung der Hülse 3 durch einen Stromfluss I liegt ein einheitlicher magnetoresistiver Effekt im ganzen ringförmigen Bereich vor. Befindet sich der Leiter 4 mit der magnetoresistiven Hülse 3 in einem homogenen Störfeld, wird auf einer Seite der Hülse durch Überlagerung von Leiterfeld H und Störfeld das resultierende Feld geschwächt. Auf der gegenüberliegenden Seite des Leiters und damit der Hülse wird das Feld jedoch aus den gleichen Gründen erhöht. Wegen der Symmetrie der Anordnung kann für die Hülse ein Ersatzschaltbild mit zwei parallel geschalteten Widerständen $R_0$ angenommen werden. Deshalb ergibt sich folgender Gesamtwiderstand R gemäß der Beziehung

$$\frac{1}{R} = \frac{1}{R_0} + \frac{1}{R_0} = \frac{2}{R_0}, \quad d.h. \quad R = \frac{R_0}{2}.$$

2) Die rotationssymmetrische Aufmagnetisierung mit geschlossenem Fluss wird durch ein homogen überlagertes Störfeld in seiner Symmetrie aufgebrochen. Es tritt dann ein unterschiedlicher magnetoresistiver Effekt in gegenüberliegenden Halbseiten der Hülse 3 auf. Vereinfacht kann man sich so für die Hülse ein Ersatzschaltbild mit zwei parallel geschalteten Widerständen ($R_0 + R_{st}$) vorstellen, wobei $R_{st}$ der mit dem überlagerten Störfeld verbundene Widerstand sein soll. Es ergibt sich dann folgende Beziehung

$$\frac{1}{R} = \frac{1}{R_0 + R_{st}} + \frac{1}{R_0 - R_{st}} = \frac{2R_0}{R_0 - R_{st}^2},$$

d.h.

$$ R \;=\; \frac{R_0}{2} \;-\; \left[\frac{1}{2}\frac{R_{st}^{\,2}}{R_0}\right] \;.$$

In diesem Falle ist die lineare Störung in der Magnetisierung der zwei parallel geschalteten Pfade zwar nicht wie im Fall 1) einer seriellen Anordnung vollständig kompensiert; sie tritt im magnetoresistiven Effekt jedoch nur als Störung 2. Ordnung auf und ist deshalb von untergeordneter Bedeutung.

Aus beiden Abschätzungen ersieht man jedoch, dass mit der erfindungsgemäßen Verwendung einer in Umfangsrichtung magnetisch vollständig geschlossenen Schleife als Sensorelement im rotationssymmetrischen Feld des Leiters Störfelder nur einen verhältnismäßig geringen Einfluss ausüben. Mit der erfindungsgemäß gestalteten Strommessvorrichtung steht somit eine universale, einfach integrierbare Sensorlösung zur Überwachung und Detektion sowohl von DC- als auch AC-Strömen zur Verfügung.

## Patentansprüche

1. Vorrichtung (2) zur potenzialfreien Messung eines in einem axial lang gestreckten elektrischen Leiter (4) fließenden Leiterstromes (I) mit mindestens einem dem Leiter (4) zugeordneten, demgegenüber elektrisch isolierenden Sensorelement (3) mit magnetoresistiven Eigenschaften und mit Mitteln zum Abgriff des vom Magnetfeld des Stromes (I) abhängigen Widerstandswertes (R) über dem Element (3) und zur Weiterverarbeitung dieses Wertes, wobei das mindestens eine aus magnetoresistivem Material gebildete Sensorelement (3, 3a bis 3d, 13) eine in Umfangsrichtung um den Leiter (4) magnetisch geschlossene Schleife bildet, **dadurch gekennzeichnet, dass** der Abgriff des Widerstandeswertes (R) axial an gegenüberliegenden Enden (7a, 7b) des mit einer axial ausgeprägten Ausdehnung (a) gestalteten Sensorelementes (3, 3a bis 3d, 13) erfolgt.

2. Vorrichtung nach Anspruch 1, **dadurch gekennzeichnet, dass** die axiale Ausdehnung (a) mindestens 1 mm beträgt.

3. Vorrichtung nach Anspruch 1 oder 2, **dadurch gekennzeichnet, dass** der magnetoresistive Teil des Sensorelementes (3, 3a bis 3d, 13) aus einem metallischen oder nicht-metallischen Material ausgebildet ist.

4. Vorrichtung nach Anspruch 3, **dadurch gekennzeichnet, dass** das metallische Material vom AMR-Typ ist.

5. Vorrichtung nach Anspruch 3, **dadurch gekennzeichnet, dass** das nicht-metallische Material ein Pulver-Material, insbesondere ein Pulver-Verbundmaterial, mit hohem magnetoresistiven Effekt ist.

6. Vorrichtung nach Anspruch 5, **dadurch gekennzeichnet, dass** das Pulver-Verbundmaterial Partikel aus wenigstens einer Heusler- oder Halb-Heusler-Phase enthält, denen ein geringer Anteil mindestens eines oxidischen Materials zugemischt ist.

7. Vorrichtung nach Anspruch 6, **dadurch gekennzeichnet, dass** der Anteil des oxidischen Materials in dem Pulver-Verbundmaterial unter 25 Vol.-% liegt.

8. Vorrichtung nach Anspruch 6 oder 7, **dadurch gekennzeichnet, dass** als oxidisches Material ein Chrom- oder Aluminiumoxid gewählt ist.

9. Vorrichtung nach Anspruch 5, **dadurch gekennzeichnet, dass** das Pulver-Material Partikel aus wenigstens einer Mangan-Perowskit-Phase enthält.

10. Vorrichtung nach Anspruch 9, **dadurch gekennzeichnet, dass** das Pulver-Material ein Verbundmaterial ist, dem ein geringer Anteil eines organischen Materials zugemischt ist.

11. Vorrichtung nach Anspruch 10, **dadurch gekennzeichnet, dass** der Anteil des organischen Materials in dem Pulver-Verbundmaterial unter 25 Vol.-% liegt.

12. Vorrichtung nach Anspruch 10 oder 11, **dadurch gekennzeichnet, dass** als organisches Material ein Polymer gewählt ist.

**13.** Vorrichtung nach einem der vorangehenden Ansprüche, **dadurch gekennzeichnet, dass** die magnetisch geschlossene Schleife durch eine Ring- oder Hülsenform des Sensorelementes (3, 3a bis 3d, 13) gebildet ist.

**14.** Vorrichtung nach einem der vorangehenden Ansprüche, **dadurch gekennzeichnet, dass** mehrere Sensorelemente (3a bis 3d) in der axialen Längsrichtung des Leiters (4) gesehen hintereinander angeordnet sind.

**15.** Vorrichtung nach Anspruch 14, **dadurch gekennzeichnet, dass** die Sensorelemente (3a bis 3d) zu einer Voll- oder Teilbrücke verschaltet sind, wobei die in die Längsrichtung weisenden Vorzugsrichtungen der Magnetisierungen ($m_a$ bis $m_d$) von Element zu Element entgegengesetzt gerichtet sind.

**16.** Vorrichtung nach einem der vorangehenden Ansprüche, **dadurch gekennzeichnet, dass** das mindestens eine Sensorelement (13) in mehrere in Umfangsrichtung um den Leiter (4) gesehen verteilt angeordnete Teilelemente (13a bis 13d) unterteilt ist.

**17.** Vorrichtung nach Anspruch 15, **dadurch gekennzeichnet, dass** die Teilelemente (13a bis 13d) zu einer Voll- oder Teilbrücke verschaltet sind, wobei die in die Längsrichtung weisenden Vorzugsrichtungen der Magnetisierungen ($m_a$ bis $m_d$) von Teilelement zu Teilelement entgegengesetzt gerichtet sind.

**18.** Vorrichtung nach einem der vorangehenden Ansprüche, **dadurch gekennzeichnet, dass** das mindestens eine Sensorelement (3, 3a bis 3d, 13) mit einer hochpermeablen Abschirmhülse (15) versehen ist.

### Claims

**1.** Apparatus (2) for floating measurement of a conductor current (I) which is flowing in an axially elongated electrical conductor (4), having at least one sensor element (3) which is associated with the conductor (4) that is electrically isolated from it and has magnetoresistive characteristics, and having means for tapping off the resistance value (R), which is dependent on the magnetic field of the current (I), across the element (3) and for further processing of this value, the at least one sensor element (3, 3a to 3d, 13) which is formed from magnetoresistive material forming a loop which is magnetically closed around the conductor (4) in the circumferential direction, **characterized in that** the resistance value (R) is tapped off axially at opposite ends (7a, 7b) of the sensor element (3, 3a to 3d, 13) which has an axially pronounced extent (a).

**2.** Apparatus according to Claim 1, **characterized in that** the axial extent (a) is at least 1 mm.

**3.** Apparatus according to Claim 1 or 2, **characterized in that** the magnetoresistive part of the sensor element (3, 3a to 3d, 13) is formed from a metallic or non-metallic material.

**4.** Apparatus according to Claim 3, **characterized in that** the metallic material is of the AMR type.

**5.** Apparatus according to Claim 3, **characterized in that** the non-metallic material is a powder material, in particular a powder composite material, with a high magnetoresistive effect.

**6.** Apparatus according to Claim 5, **characterized in that** the powder composite material contains particles composed of at least one Heusler or half-Heusler phase, to which a small proportion of at least one oxide material is added.

**7.** Apparatus according to Claim 6, **characterized in that** the proportion of the oxide material in the powder composite material is less than 25% by volume.

**8.** Apparatus according to Claim 6 or 7, **characterized in that** a chromium or aluminium oxide is chosen as the oxide material.

**9.** Apparatus according to Claim 5, **characterized in that** the powder material contains particles composed of at least one manganese Perovskite phase.

**10.** Apparatus according to Claim 9, **characterized in that** the powder material is a composite material to which a small proportion of an organic material is added.

**11.** Apparatus according to Claim 10, **characterized in that** the proportion of the organic material in the powder composite material is less than 25% by volume.

**12.** Apparatus according to Claim 10 or 11, **characterized in that** a polymer is chosen as the organic material.

**13.** Apparatus according to one of the preceding claims, **characterized in that** the magnetically closed loop is formed by the sensor element (3, 3a to 3d, 13) being in the form of a ring or sleeve.

**14.** Apparatus according to one of the preceding claims, **characterized in that** two or more sensor elements (3a to 3d) are arranged one behind the other in the axial longitudinal direction of the conductor (4).

**15.** Apparatus according to Claim 14, **characterized in that** the sensor elements (3a to 3d) are connected to form a full bridge or partial bridge, with the preferred directions (which point in the longitudinal direction) of the magnetizations ($m_a$ to $m_d$) being in opposite directions from one element to the next.

**16.** Apparatus according to one of the preceding claims, **characterized in that** the at least one sensor element (13) is subdivided into two or more partial elements (13a to 13d) which are arranged distributed in the circumferential direction around the conductor (4).

**17.** Apparatus according to Claim 15, **characterized in that** the partial elements (13a to 13d) are connected to form a full bridge or partial bridge, with the preferred directions (which point in the longitudinal direction) of the magnetizations ($m_a$ to $m_d$) being in opposite directions from one partial element to the next.

**18.** Apparatus according to one of the preceding claims, **characterized in that** the at least one sensor element (3, 3a to 3d, 13) is provided with a high-permeability shielding sleeve (15).

**Revendications**

**1.** Dispositif (2) pour la mesure hors potentiel d'un courant (I) passant dans un conducteur électrique (4) s'étendant en longueur axialement, comprenant au moins un élément de capteur (3) à propriétés magnéto résistives, affecté au conducteur (4) en en étant isolé électriquement et comprenant des moyens pour prélever la valeur de résistance (R) fonction du champ magnétique du courant (I) sur l'élément (3) et pour traiter davantage cette valeur, l'au moins un élément de capteur (3, 3a à 3d, 13) constitué d'un matériau magnétorésistif formant une boucle fermée magnétiquement dans la direction périphérique autour du conducteur (4), **caractérisé en ce que** le prélèvement de la valeur de résistance (R) s'effectue axialement en des extrémités (7a, 7b) opposées de l'élément de capteur (3, 3a à 3d, 13) conçu avec une étendue axiale (a) marquée.

**2.** Dispositif selon la revendication 1, **caractérisé en ce que** l'étendue (a) axiale est au moins de 1 mm.

**3.** Dispositif selon la revendication 1 ou 2, **caractérisé en ce que** la partie magnétorésistive de l'élément de capteur (3, 3a à 3d, 13) est en un matériau métallique ou non métallique.

**4.** Dispositif selon la revendication 3, **caractérisé en ce que** le matériau métallique est du type AMR (de Anisotropic Magneto Resistance).

**5.** Dispositif selon la revendication 3, **caractérisé en ce que** le matériau non métallique est un matériau en poudre, notamment un matériau composite en poudre, avec un grand effet magnétorésistif .

**6.** Dispositif selon la revendication 5, **caractérisé en ce que** le matériau composite de poudre renferme des particules d'au moins une phase de Heusler ou demi-phase de Heusler, auxquelles est mélangée une proportion d'un matériau oxydé.

**7.** Dispositif selon la revendication 6, **caractérisé en ce que** la proportion du matériau oxydé dans le matériau composite en poudre se situe en-dessous de 25% en volume.

**8.** Dispositif selon la revendication 6 ou 7, **caractérisé en ce qu'**en guise de matériau oxydé on choisit un oxyde de chrome ou d'aluminium.

9. Dispositif selon la revendication 5, **caractérisé en ce que** le matériau en poudre renferme des particules d'au moins une phase de manganèse-pérovskite.

10. Dispositif selon la revendication 9, **caractérisé en ce que** le matériau en poudre est un matériau composite auquel est mélangé une petite proportion d'un matériau organique.

11. Dispositif selon la revendication 10, **caractérisé en ce que** la proportion du matériau organique dans le matériau composite de poudre se situe en-dessous de 25% en volume.

12. Dispositif selon la revendication 10 ou 11, **caractérisé en ce qu'**en guise de matériau organique on choisit un polymère.

13. Dispositif selon l'une des revendications précédentes, **caractérisé en ce que** la boucle fermée magnétiquement est réalisée par une forme d'anneau ou de douille de l'élément de capteur (3, 3a à 3d, 13).

14. Dispositif selon l'une des revendications précédentes, **caractérisé en ce que** plusieurs éléments de capteur (3a à 3d) sont disposés les uns à la suite des autres dans la direction longitudinale axiale du conducteur (4).

15. Dispositif selon la revendication 14, **caractérisé en ce que** les éléments de capteur (3a à 3d) sont commutés selon un circuit en pont complet ou partiel, les directions préférentielles des magnétisations ($m_a$ à $m_d$) orientées dans la direction longitudinale étant respectivement de sens opposé d'un élément à un autre élément.

16. Dispositif selon l'une des revendications précédentes, **caractérisé en ce que** l'au moins un élément de capteur (13) est subdivisé en plusieurs éléments partiels (13a, à 13d) agencés de manière répartie dans la direction périphérique autour du conducteur (4).

17. Dispositif selon la revendication 15, **caractérisé en ce que** les éléments partiels (13a, 13d) sont commutés selon un circuit en pont complet ou partiel, les directions préférentielles des magnétisations ($m_a$ à $m_d$) orientées dans la direction longitudinale étant respectivement de sens opposé d'un élément partiel à un autre élément partiel.

18. Dispositif selon l'une des revendications précédentes, **caractérisé en ce que** l'au moins un élément de capteur (3, 3a à 3d, 13) est muni d'une douille de blindage (15) très perméable.

FIG 1

a

H

I

3

2

5

7b  $i_{mess}$

4

7a

R(H(I))

FIG 2

$m_a$  $m_b$  $m_c$  $m_d$

4

3a  3b  3c  3d

a

10

FIG 3

FIG 4

FIG 5

FIG 6